# EUROPEAN PATENT APPLICATION

(11) **EP 4 704 150 A1**
(43) Date of publication of application: **04.03.2026**
(21) Application number: 24797088.2
(22) Date of filing: 24.04.2024
(51) Int. Cl.: H01L 23/373, C22C 1/10, C22C 21/00, C22C 21/02, C22C 21/06, C22C 21/12, C22C 26/00, H01L 23/36

(54) **ALUMINUM-DIAMOND COMPOSITE, METHOD FOR PRODUCING ALUMINUM-DIAMOND COMPOSITE, AND SEMICONDUCTOR PACKAGE**

(30) Priority: 28.04.2023 JP 2023075161
(71) Applicant: Denka Company Limited, Tokyo 103-8338 (JP)
(72) Inventor: OTA, Hiroaki, Tokyo 103-8338 (JP); GOTO, Daisuke, Tokyo 103-8338 (JP)
(74) Representative: Müller-Boré & Partner Patentanwälte PartG mbB
(86) International application number: PCT/JP2024/016149
(87) International publication number: WO 2024/225342

(57) **Abstract**

The aluminum-diamond composite according to the present disclosure is an aluminum-diamond composite provided with a laminated structure having a composite layer including an aluminum phase and a plurality of diamond particles having different sizes from one another, and a pair of aluminum layers sandwiching the composite layer, wherein: in a cut section obtained by cutting along the laminating direction, the plurality of diamond particles include coarse particles having a surface area of 2000 µm² or more and fine particles having a surface area of less than 2000 µm²; and in a region extending 200 µm into the composite layer from a boundary line between the pair of aluminum layers and the composite layer, an average value α of a ratio of the total surface area of the coarse particles relative to the total surface area of the plurality of diamond particles is 65-80%.

## Description

### TECHNICAL FIELD

The present disclosure relates to an aluminum-diamond composite, a method for producing an aluminum-diamond composite, and a semiconductor package.

### BACKGROUND

An aluminum-diamond composite is a material in which diamond having a high thermal conductivity and aluminum having a high thermal expansion coefficient are composited. Aluminum-diamond composites are used in various kinds of materials such as heat sinks, etc. Patent Document 1 discloses an aluminum-diamond-based composite heat dissipation component. Further, Patent Document 2 discloses a semiconductor package which uses such a composite.

### CITATION LIST

### PATENT LITERATURE

Patent Document 1: JP 2014-107468 A
Patent Document 2: WO 2015/182576 A

### SUMMARY OF INVENTION

### TECHNICAL PROBLEM

An aluminum-diamond composite is formed by dispersing diamond particles in an aluminum phase. Accordingly, it is thought that the thermal conductivity of a composite can be improved by adjusting the size, particle count, and distribution of the diamond particles in the aluminum phase. The present disclosure provides: an aluminum-diamond composite having a sufficiently high thermal conductivity; and a method for producing the same. The present disclosure provides a semiconductor package which has excellent heat dissipation due to including such an aluminum-diamond composite.

### SOLUTION TO PROBLEM

One aspect of the present disclosure provides the aluminum-diamond composite described below.
[1] An aluminum-diamond composite provided with a laminated structure having a composite layer including an aluminum phase and a plurality of diamond particles having different sizes from one another, and a pair of aluminum layers sandwiching the composite layer, wherein:
   in a cut section obtained by cutting along the laminating direction,
   the plurality of diamond particles include coarse particles having a surface area of 2000 µm² or more and fine particles having a surface area of less than 2000 µm²; and
   in a region extending 200 µm into the composite layer from a boundary line between the pair of aluminum layers and the composite layer, an average value α of a ratio of the total surface area of the coarse particles relative to the total surface area of the plurality of diamond particles is 65-80%.

For the aluminum-diamond composite in [1] above, in a prescribed region of a cut section, the average value α of a ratio of the surface area of the coarse diamond particles relative to the total surface area of the coarse diamond particles and the fine diamond particles is 65-80%. In such an aluminum-diamond composite, diamond particles having a high thermal conductivity are densely distributed in the aluminum phase, and therefore, the aluminum-diamond composite has a high thermal conductivity.

The aluminum-diamond composite in [1] above may also be any one of [2] to [4] below.
[2] The aluminum-diamond composite described in [1], wherein in said region, an average value β of a ratio of a particle count of the coarse particles relative to a particle count of the plurality of diamond particles is 2.0% or less.
[3] The aluminum-diamond composite described in [1] or [2], wherein:
   the region includes a first region which is a region extending 200 µm into the composite layer from a boundary line between one of the pair of aluminum layers and the composite layer, and a second region which is a region extending 200 µm into the composite layer from a boundary line between the other of the aluminum layers and the composite layer; and
   an absolute value of a difference between an average value β1 of a ratio of the particle count of the coarse particles relative to the particle count of the plurality of diamond particles in the first region, and an average value β2 of a ratio of the particle count of the coarse particles relative to the particle count of the plurality of diamond particles in the second region is 0.6% or less.
[4] The aluminum-diamond composite described in any of [1] to [3], wherein:
   the region includes a first region which is a region extending 200 µm into the composite layer from a boundary line between one of the pair of aluminum layers and the composite layer, and a second region which is a region extending 200 µm into the composite layer from a boundary line between the other of the aluminum layers and the composite layer; and
   an absolute value of a difference between an average value α1 of a ratio of the total surface area of the coarse particles relative to the total surface area of the plurality of diamond particles in the first region, and an average value α2 of a ratio of the total surface area of the coarse particles relative to the total surface area of the plurality of diamond particles in the second region is 6.0% or less.

For the aluminum-diamond composite in [2] above, in a region of a cut section, the average value β of a ratio of the particle count of the coarse particles relative to the particle count of the plurality of diamond particles is 2.0% or less. Such an aluminum-diamond composite has an even higher thermal conductivity.

For the aluminum-diamond composite in [3] above, the absolute value of a difference between the average value β1 of the particle count ratio in the first region and the average value β2 of the particle count ratio in the second region is 0.6% or less. In such an aluminum-diamond composite, variation in coarse particle distribution is sufficiently reduced, and therefore, the aluminum-diamond composite has an even higher thermal conductivity.

For the aluminum-diamond composite in [4] above, the absolute value of a difference between the average value α1 of the surface area ratio in the first region and the average value α2 of the surface area ratio in the second region is 6.0% or less. In such an aluminum-diamond composite, variation in coarse particle distribution is sufficiently reduced, and therefore, the aluminum-diamond composite has an even higher thermal conductivity.

One aspect of the present disclosure provides the method for producing an aluminum-diamond composite described below.

[5] A method for producing an aluminum-diamond composite, the method including: a mixing step in which a V-type mixer is used to mix coarse diamond particles and fine diamond particles that have different sizes from one another to obtain a mixture including a plurality of diamond particles; and
a heating step in which the mixture is heated in a state of being sandwiched by aluminum foil to obtain a laminated structure provided with a composite layer including an aluminum phase and the mixture, and a pair of aluminum layers sandwiching the composite layer.

The method for producing an aluminum-diamond composite in [5] above has a mixing step for mixing coarse diamond particles and fine diamond particles using a V-type mixer. In a method for producing an aluminum-diamond composite that has such a mixing step, the coarse diamond particles and the fine diamond particles are mixed with a high uniformity, and therefore, it is possible to obtain an aluminum-diamond composite having a high thermal conductivity.

The aluminum-diamond composite in [5] above may also be any one of [6] to [8] below.

[6] The method for producing an aluminum-diamond composite described in [5], wherein:
in a cut section obtained by cutting the aluminum-diamond composite along the laminating direction,
the plurality of diamond particles include the coarse particles which have a surface area of 2000 µm² or more and the fine particles which have a surface area of less than 2000 µm²; and
in a region extending 200 µm into the composite layer from a boundary line between the pair of aluminum layers and the composite layer, an average value α of a ratio of the total surface area of the coarse particles relative to the total surface area of the plurality of diamond particles is 65-80%.

[7] The method for producing an aluminum-diamond composite described in [5] or [6], wherein the method includes, in the mixing step, rotating the V-type mixer at a rotational speed of 15-50 rpm for 5-30 minutes.

[8] The method for producing an aluminum-diamond composite described in any one of [5] to [7], wherein in the mixing step, a ratio of the volume of the plurality of diamond particles relative to the total capacity of the V-type mixer is 10-50%.

For the method for producing an aluminum-diamond composite in [6] above, in a region of a cut section of the aluminum-diamond composite, an average value α of a ratio of the surface area of the coarse diamond particles relative to the total surface area of the coarse diamond particles and the fine diamond particles is 65-80%. In such a method for producing an aluminum-diamond composite, diamond particles having a high thermal conductivity are densely distributed in the aluminum phase, and therefore, it is possible to obtain an aluminum-diamond composite having a high thermal conductivity.

The method for producing an aluminum-diamond composite in [7] above includes, in the mixing step, rotating the V-type mixer at a rotational speed of 15-50 rpm for 5-30 minutes. In such a method for producing an aluminum-diamond composite, the diamond particles can be mixed with an even higher uniformity, and therefore, it is possible to obtain an aluminum-diamond composite having an even higher thermal conductivity.

In the method for producing an aluminum-diamond composite in [8] above, the ratio of the volume of the plurality of diamond particles relative to the total capacity of the V-type mixer is 10-50%. In such a method for producing an aluminum-diamond composite, the diamond particles can be mixed with an even higher uniformity, and therefore, it is possible to obtain an aluminum-diamond composite having an even higher thermal conductivity.

One aspect of the present disclosure provides the semiconductor package described below.

[9] A semiconductor package provided with: a heat dissipation member including the aluminum-diamond composite described in any one of [1] to [4] above or an aluminum-diamond composite obtained by the production method described in any one of [5] to [8] above; and a semiconductor element bonded to the heat dissipation member.

The semiconductor package in [9] above is provided with a heat dissipation member which includes the aluminum-diamond composite described above. Accordingly, the semiconductor package has a high thermal conductivity.

### EFFECTS OF INVENTION

The present disclosure can provide: an aluminum-diamond composite having a sufficiently high thermal conductivity; and a method for producing the same. The present disclosure can provide a semiconductor package which has excellent heat dissipation due to including such an aluminum-diamond composite.

### BRIEF DESCRIPTION OF DRAWINGS

FIG. 1 shows an example of a cross section in the laminating direction of an aluminum-diamond composite.
FIG. 2 is an enlarged view of a portion of a boundary section between a first aluminum layer and a first region in a cross section in the laminating direction of an aluminum-diamond composite.
FIG. 3 shows an example of block-forming step in a method for producing an aluminum-diamond composite.
FIG. 4 shows an example of a heating step in a method for producing an aluminum-diamond composite.
FIG. 5 shows an example of a semiconductor package which uses a heat dissipation member including an aluminum-diamond composite.
FIG. 6 is an SEM photograph of a cut section of aluminum-diamond composite No. 1 in Example 1.
FIG. 7 is an SEM photograph of a cut section of aluminum-diamond composite No. 2 in Example 1.
FIG. 8 is an SEM photograph of a cut section of aluminum-diamond composite No. 3 in Example 1.
FIG. 9 is an SEM photograph of a cut section of aluminum-diamond composite No. 4 in Example 1.

### DESCRIPTION OF EMBODIMENTS

Embodiments of the present disclosure are described below. However, the following embodiments are examples disclosed in order to describe the present disclosure and are not intended to limit the present disclosure to the details described below. An upper limit value or a lower limit value of a numerical value range explicitly disclosed herein may be substituted by a value shown in any example. Further, an upper limit value and a lower limit value disclosed individually may be combined arbitrarily. In the absence of any particular restrictions, materials or components provided as examples herein may be used alone or in combinations of two or more. In descriptions, the same reference sign is used for elements which are the same or have the same function, and duplicate descriptions are omitted. Further, in the absence of any particular restrictions, positional relationships such as up, down, left, and right, etc., used in descriptions are used on the basis of positional relationships shown in the drawings. A hyphen "-" used in a numerical value range indicates a numerical value range which includes the upper limit and the lower limit numerical values. For example, "X-Y" indicates the numerical value range "X or more and Y or less".

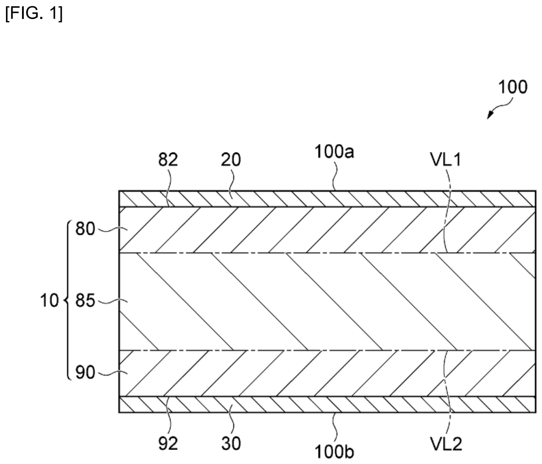

FIG. 1 shows a cut section obtained by cutting along the laminating direction of an aluminum-diamond composite according to a first embodiment. An aluminum-diamond composite 100 is provided with, in order, a first aluminum layer 20, a composite layer 10, and a second aluminum layer 30.

As long as plate-shaped, the shape of the aluminum-diamond composite 100 is not particularly limited. The thickness of the aluminum-diamond composite 100 may be 1.0-3.0 mm or may be 1.2-2.5 mm.

The composite layer 10 includes an aluminum phase and a plurality of diamond particles that have different sizes from one another. The diamond particles may be natural diamond, may be artificial diamond, or may be a mixture thereof. Further, the diamond particles include coarse particles having a large particle diameter and fine particles having a small particle diameter. The average particle diameter of the coarse particles may be 100-250 µm or may be 140-210 µm. The average particle diameter of the fine particles may be 5-30 µm or may be 10-25 µm. The diamond particles may be diamond particles having a high purity or may include a binder such as silica, etc. The respective average particle diameters of the diamond particles, the coarse particles, and the fine particles can be measured, in compliance with the descriptions in ISO 13320: 2009, by using a laser diffraction/scattering-method particle size distribution measuring device. As a laser diffraction/scattering-method particle size distribution measuring device, it is possible to use, for example, an "LS-13 320" (device name), manufactured by Beckman Coulter, Inc. In a volume-based particle diameter distribution (cumulative distribution) with a logarithmic scale particle diameter [µm] shown on the horizontal axis and frequency [vol.%] shown on the vertical axis, the particle diameter at which an integrated value from a small particle diameter reaches 50% of the total is the average particle diameter (D50) described above.

As the diamond particles, it is also possible to use diamond particles which have a β-type silicon carbide layer formed on a surface thereof. Such diamond particles can suppress the generation of metal carbides having a low thermal conductivity (for example, aluminum carbide (Al₄C₃)), and thus, can improve the thermal conductivity of the aluminum-diamond composite 100.

The thickness of the composite layer 10 may be 0.5-2.5 mm, may be 0.8 mm-2.2 mm, or may be 1.0-1.8 mm.

The mass ratio of the coarse particles relative to the total mass of the diamond particles in the composite layer 10 may be 60 mass% or more, may be 70 mass% or more, or may be 90 mass% or more. The range of the mass ratio of the coarse particles may, for example, be 60-90 mass% or 70-90 mass%. Further, the mass ratio of the fine particles relative to the total mass of the diamond particles may be 40 mass% or less, may be 30 mass% or less, or may be 10 mass% or less. The range of the mass ratio of the fine particles may, for example, be 10-30 mass% or 10-40 mass%. Due to the diamond particles having such a mass ratio of coarse particles and fine particles, the diamond particles can be dispersed with high uniformity in the aluminum phase and the thermal conductivity of the aluminum-diamond composite 100 can be improved.

The aluminum phase may include aluminum as a main component and may include a metal other than aluminum. Examples of metals other than aluminum include silicon, magnesium, and copper, etc. By including such a metal, the aluminum phase can sufficiently penetrate gaps in the diamond particles and it is possible to obtain an even denser composite layer 10.

The aluminum-diamond composite 100 has a first aluminum layer 20 and a second aluminum layer 30 which are provided so as to sandwich the composite layer 10. By having such aluminum layers, the main surfaces 100a, 100b of the aluminum-diamond composite 100 can be made smooth and plating properties can be improved.

The thicknesses of the first aluminum layer 20 and the second aluminum layer 30 may be 10-100 µm or may be 20-80 µm. Due to the thicknesses of the first aluminum layer 20 and the second aluminum layer 30 being in the foregoing ranges, the thermal conductivity of the aluminum-diamond composite 100 can be raised while also improving surface plating properties.

The lower limit value of the aluminum content in the first aluminum layer 20 and the second aluminum layer 30 may, for example, be 80 mass%, 82 mass%, 84 mass%, or 86 mass%. The upper limit value of the aluminum content may, for example, be 100 mass%, 98 mass%, 96 mass%, 94 mass%, 92 mass%, or 90 mass%.

The aluminum-diamond composite 100 may have a plating layer on the main surfaces 100a, 100b. The plating layer may include, in order from the aluminum-diamond composite 100-side, a nickel plating layer and a gold plating layer. In such a case, the average thickness of the nickel plating layer may be 0.5-6.5 µm and the average thickness of the gold plating layer may be 0.5 µm or more. By setting the average thickness of the nickel plating layer within the range described above, it is possible to suppress incidences of flaws such as pinholes, etc., in the plating layer, and even when a plated component is used in a high-temperature environment, it is possible to suppress incidences of the plating film peeling and cracks, etc., in a more adequate manner.

A general plating method can be used to form the plating layer. Examples of plating methods include electrolytic plating methods and non-electrolytic plating methods, etc. When nickel plating is to be performed on the first aluminum layer 20 and the second aluminum layer 30, a pretreatment may be performed in which at least a portion of the main surfaces 100a, 100b of the aluminum-diamond composite 100 is replaced with zinc, etc. By performing such a pretreatment, it is possible to further improve the density of the plating layer.

When nickel plating is performed to form a nickel plating layer, an amorphous nickel alloy plating film having a thickness of 0.5-6.5 µm may be formed on a surface of the nickel plating layer. In such a case, it is possible to suppress incidences of pinholes, etc., in the surface of the aluminum-diamond composite even if diamond particles are exposed. The amorphous nickel alloy plating may be formed by means of a non-electrolytic plating method. In such a case, the amorphous nickel alloy plating may be an alloy plating containing, for example, 5-15 mass% of nickel and phosphorus (P)

Further, there may be cases in which the amorphous nickel alloy plating crystallizes as bonding temperature increases or as temperature load during actual use increases. Volumetric changes at such a time may cause microcracks, and thereafter the cracks may extend due to temperature load. Therefore, the thickness of the nickel alloy plating may, for example, be 0.5-2 µm.

In cases of being used in applications in which bonding by means of brazing at high temperatures is performed, it is desirable that a gold plating layer is provided to the outermost surface of a plated component. From the perspective of making a bond sufficiently robust, the thickness of the gold plating may, for example, be 0.01 µm or more. From the perspective of suppressing costs, the thickness of the gold plating may, for example, be 4.0 µm or less.

In the cut section of the aluminum-diamond composite 100 shown in FIG. 1, the composite layer 10 is sub-divided into three band-like regions by a first virtual line VL1 which extends parallel to the main surface 100a and a second virtual line VL2 which extends parallel to the main surface 100b. The three band-like regions are, aligned in order from the first aluminum layer 20 toward the second aluminum layer 30: a first region 80; a central region 85; and a second region 90. The first virtual line VL 1 is drawn at a position 200 µm toward the inside of the composite layer 10 from a first boundary line 82 between the first aluminum layer 20 and the composite layer 10. The second virtual line VL 2 is drawn at a position 200 µm toward the inside of the composite layer 10 from a second boundary line 92 between the second aluminum layer 30 and the composite layer 10.

The first region 80, which is demarcated by the first boundary line 82 and the first virtual line VL1, is a band-like region that extends 200 µm toward the inside of the composite layer 10 from the first boundary line 82 between the first aluminum layer 20 and the composite layer 10. The second region 90, which is demarcated by the second boundary line 92 and the second virtual line VL2, is a band-like region that extends 200 µm toward the inside of the composite layer 10 from the second boundary line 92 between the second aluminum layer 30 and the composite layer 10. The central region 85 is a band-like region which is demarcated by the first virtual line VL1 and the second virtual line VL2. That is, the central region 85 is located between the first region 80 and the second region 90. Having the central region 85 is not essential. The first virtual line VL1 and the second virtual line VL2 may overlap. That is, the thickness of the composite layer 10 may be 400 µm or more. The thickness (length in the laminating direction) of the composite layer 10 may be 1000 µm or more or 3000 µm or more.

The cut section of the aluminum-diamond composite 100 can be obtained by cutting along the laminating direction (direction orthogonal to the main surfaces 100a, 100b) of the first aluminum layer 20, the composite layer 10, and the second aluminum layer 30. Cutting may be performed by a water jet process or a laser process, etc., or may be performed manually by a worker. As long as the cutting position is in a section including the first aluminum layer 20, the composite layer 10, and the second aluminum layer 30, the cutting position may be anywhere without any particular limitations. However, in order to obtain average values α and β described below, it is preferable that four or more cut sections are observed.

The cut section of the aluminum-diamond composite 100 may be obtained by a process using a cross section polisher (manufactured by JEOL, Ltd.). By observing such a cut section using a scanning electron microscope (SEM), it is possible to obtain values such as average values α, β, etc. The magnification of the SEM may be 50-100 X or may be 60-90 X.

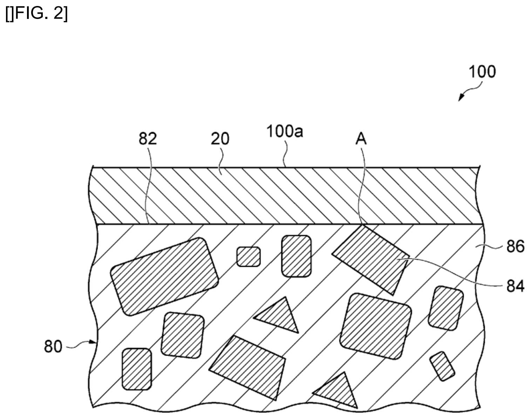

FIG. 2 is a cross-sectional view showing an enlargement of a boundary section between the first aluminum layer 20 and the first region 80 in the cut section shown in FIG. 1. The first boundary line 82 touches an outer edge A of a diamond particle 84 which, among the diamond particles 84 dispersed in an aluminum phase 86 of the composite layer 10, is the closest diamond particle 84 to the first aluminum layer 20, and is a tangent parallel to the main surface 100a. As long as the first boundary line 82 is parallel to the main surface 100a, the first boundary line 82 may touch an outer edge of a plurality of the diamond particles 84. In the same manner as the first boundary line 82, the second boundary line 92 also touches an outer edge of a diamond particle 84 which, among the diamond particles 84 in the composite layer 10, is the closest diamond particle 84 to the second aluminum layer 30, and is a tangent parallel to the main surface 100b. The first boundary line 82 and the second boundary line 92 may be drawn using image analysis or may be drawn visually on an SEM photograph.

Among the plurality of diamond particles in the first region 80 and the second region 90 of the cut section described above, particles having a surface area of 2000 µm² or more are deemed to be coarse particles, and particles having a surface area of less than 2000 µm² are deemed to be fine particles. The surface area and particle count of the coarse particles and the fine particles in the first region 80 and the second region 90 in four or more cut sections are measured and the average value α and the average value β are determined by the procedure described below. The surface area and particle count of the diamond particles in the cut section can be determined by image analysis. The image analysis may, for example, use "ImageJ". In the case of there being a diamond particle that straddles the first region 80 and the central region 85, the section included in the first region 80 is regarded as being the surface area of the diamond particle. A judgment is made as to whether the diamond particle is a fine particle or a coarse particle on the basis of said surface area. A diamond particle that straddles the first region 80 and the central region 85 is also regarded as being one particle included in the first region 80. The same also applies with respect to the second region 90.

In each of the four or more cut sections, ratios of the total surface area of the coarse particles relative to the total area of the plurality of diamond particles 84 in the first region 80 and in the second region 90 are determined. The average value α (weighted average) of the ratios in the four or more cut sections is 65-80%. The average value α may be 70-78% or may be 72-77%. With such an average value α, the coarse diamond particles can be dispersed with sufficient density in the aluminum phase and the thermal conductivity of the aluminum-diamond composite 100 can be sufficiently raised.

The absolute value of a difference between an average value α1 in the first region 80 and an average value α2 in the second region 90 may be 6.0% or less, may be 2.5% or less, or may be 0.5% or less. If the absolute value of the difference between the average value α1 in the first region 80 and the average value α2 in the second region 90 is within the ranges described above, the diamond particles can be dispersed with sufficiently high uniformity in the entirety of the composite layer 10, and therefore, the thermal conductivity of the aluminum-diamond composite 100 can be improved even further. Further, the absolute value of the difference between the average values α1 and α2 may be 0% or more.

In each of the four or more cut sections, ratios of the particle count of the coarse particles relative to the particle count of the diamond particles in the first region 80 and in the second region 90 are determined. The average value β (weighted average) of the ratios in the four or more cut sections may be 2.0% or less or may be 1.5% or less. With such an average value β, the density can be improved due to the fine diamond particles being dispersed between the coarse diamond particles, and thus, the thermal conductivity of the aluminum-diamond composite 100 can be improved even further. Further, the average value β may be 1.0% or more.

The absolute value of a difference between the average value β1 in the first region 80 and the average value β2 in the second region 90 may be 0.6% or less or may be 0.3% or less. If the absolute value of the difference between the average value β1 in the first region 80 and the average value β2 in the second region 90 is within the ranges described above, the diamond particles are dispersed with high uniformity in the entirety of the composite layer 10, and thus, the thermal conductivity of the aluminum-diamond composite 100 can be improved even further. Further, the absolute value of the difference between the average values β1 and β2 may be 0% or more.

The aluminum-diamond composite 100 has an aluminum phase which is densely filled with diamond particles, and therefore, has excellent thermal conductivity. The thermal conductivity at 25°C of the aluminum-diamond composite 100 may be 500 W/(m·K) or more or may be 550 W/(m·K) or more. Further, the thermal conductivity at 25°C may be 650 W/(m·K) or less or may be 600 W/(m·K) or less. The thermal conductivity can be measured by a laser flash method. It is possible to use, for example, "LF/TCM-8510B" (product name, manufactured by Rigaku Corp.), etc., to measure the thermal conductivity.

A method for producing an aluminum-diamond composite according to one embodiment has: a mixing step in which a mixture is obtained by mixing coarse diamond particles and fine diamond particles using a V-type mixer; and a heating step in which the obtained mixture is heated in a state of being sandwiched by aluminum foil.

The particles described above can be used as the coarse diamond particles and the fine diamond particles serving as the raw material. In the mixing step, the coarse particles and fine particles described above are loaded into a V-type mixer. By using a V-type mixer, the average value α can be set so as to be 65-80%. Further, the average value β can be set so as to be 2.0% or less. The mass ratio of the coarse particles relative to the total mass of the diamond particles that are loaded may be 60 mass% or more, may be 70 mass% or more, or may be 90 mass% or more. The numerical value range of the mass ratio of the coarse particles relative to the total mass of the diamond particles that are loaded may, for example, be 60-90 mass% or may be 70-90 mass%. Further, the mass ratio of the fine particles relative to the total mass of the diamond particles may be 40 mass% or less, may be 30 mass% or less, or may be 10 mass% or less. The numerical value range of the mass ratio of the fine particles relative to the total mass of the diamond particles may, for example, be 10-30 mass% or may be 10-40 mass%. In a mixture in which the mass ratio of the coarse particles and fine particles is within the ranges described above, the coarse particles and the fine particles can be included with a sufficiently high uniformity, and therefore, the thermal conductivity of the aluminum-diamond composite can be raised.

The capacity of the V-type mixer may, for example, be 0.1-5.0 m³ or may be 0.5-3.0 m³. As the V-type mixer, it is possible to use a "V-10" (product name, manufactured by Tokuju Co., Ltd.). Further, the volume ratio of the loaded diamond particles relative to the total capacity of V-type mixer may be 10-50%, may be 15-40%, or may be 20-40%. By loading the diamond particles at such a volume ratio, mixing efficiency is improved and it is possible to sufficiently reduce the difference between the average values α1 and α2, and the difference between the average values β1 and β2. Doing so makes it possible to obtain a mixture having an even higher uniformity, and thus, makes it possible to further raise the thermal conductivity of the aluminum-diamond composite.

In the mixing step, the rotational speed of the V-type mixer may be 15-50 rpm or may be 20-40 rpm. The rotation time of the V-mixer may be 5-30 minutes or may be 10-20 minutes. By adjusting the rotational speed and rotation time of the V-type mixer within the foregoing ranges, it is possible to sufficiently reduce the difference between the average values α1 and α2, and the difference between the average values β1 and β2. Doing so makes it possible to obtain a mixture having an even higher uniformity, and thus, makes it possible to further raise the thermal conductivity of the aluminum-diamond composite.

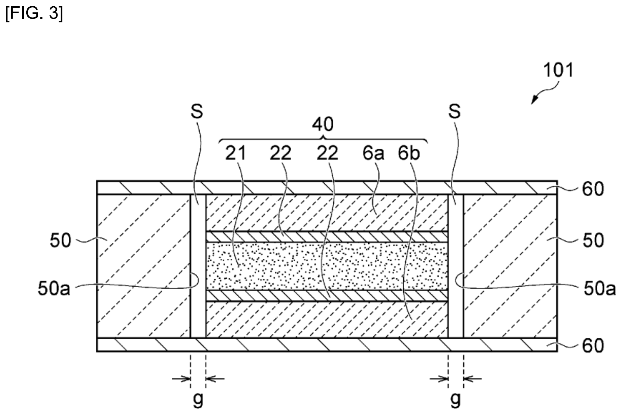

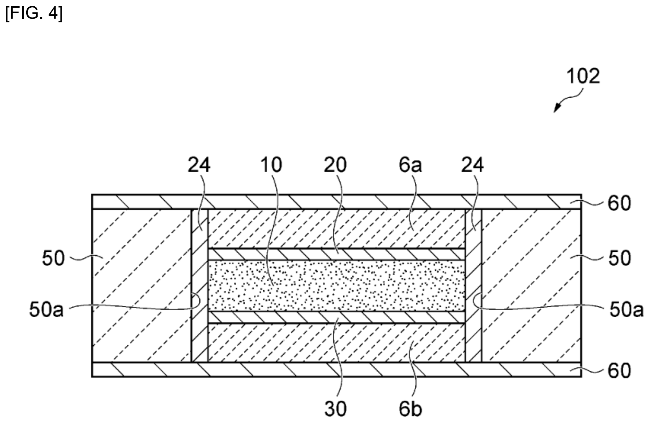

FIG. 3 and 4 are used to describe the heating step below. Before the heating step is performed, there may be included a block-forming step to obtain a structure 101 including a laminated structure 40 in which a first mold release plate 6a, an aluminum layer 22, a diamond particle mixture layer 21, an aluminum layer 22, and a second mold release plate 6b are laminated, in said order, in a space surrounded by two metal plates 60 and a porous material 50 as shown in FIG. 3 and 4.

In FIG. 3, an opening that the porous material 50 has is a through-hole which passes through in the vertical direction. However, the opening is not limited to a through-hole and may, for example, be a recessed section having an opening on one of the main surface-sides of the porous material 50. Further, from the perspective of obtaining a more uniform aluminum-diamond composite 100, it is desirable that one opening is provided in the center of the porous material 50. However, there are no particular limitations and, for example, a plurality of openings may be provided to one porous material 50. Further, a location at which the opening is formed may be adjusted, as appropriate. The following description is based on an example in which the opening is a through-hole. However, in the case of the opening being a recessed section, one of the metal plates 60 in FIG. 3 and 4 can be interpreted as being formed integrally with and from the same material as the porous material 50.

In the block-forming step, there is a step in which, at an inner side of the opening of the porous material 50, which is set between the two metal plates 60 and is a frame serving as a mold for the aluminum-diamond composite 100, the laminated structure 40 is disposed with a gap S provided therebetween so as to be separated from an inner circumferential surface 50a of the opening of the porous material 50. The method for disposing the laminated structure 40 inside the opening that the porous material 50 has is not particularly limited. The method may, for example, be a method in which the porous material 50 is set on a metal plate 60, and then each layer constituting the laminated structure 40 is sequentially laminated, or may be a method in which a separately-formed laminated structure 40 is inserted in the inner side of the opening that the porous material 50 has. The method for providing a gap S (distance g) between the inner circumferential surface 50a of the opening of the porous material 50 and the outer circumferential surface of the laminated structure 40 may, for example, be a method in which a spacer which is of a prescribed thickness and can be removed later is disposed so as to be in contact with the inner circumferential surface 50a of the opening, the laminated structure 40 is formed on or inserted into the inside (space on the opposite side to the porous material 50-side) of the spacer, and then the spacer is removed. It should be noted that FIG. 3 and 4 show an example in which one laminated structure 40 is provided but it is also possible to laminate a plurality of laminated structures 40 on the inner surface of the opening of the porous material 50 along the thickness direction of the porous material 50.

A distance g between the inner circumferential surface 50a of the opening of the porous material 50 and the outer circumferential surface of the laminated structure 40 can be adjusted in accordance with the thickness of metal layers forming side surfaces of the aluminum-diamond composite 100 to be achieved. The distance g between the inner circumferential surface 50a of the opening of the porous material 50 and the outer circumferential surface of the laminated structure 40 may, for example, be 0.05-3.50 mm, 0.05-2.50 mm, or 0.05-1.00 mm.

Examples of the metal plate 60 include iron plates and stainless steel plates, etc.

The porous material 50 may have a heat resistance which enables a molten product of an aluminum-containing metal to be press-fitted or caused to penetrate in the heating step described later. For the porous material 50, it possible to use, for example, a porous sintered body made of graphite or boron nitride (for example, an isotropic graphite-type material, etc.) or a porous material configured from alumina fibers, etc. The shape of the opening of the porous material 50 can be adjusted in accordance with the shape of the aluminum-diamond composite 100 to be achieved. In the production method of the present embodiment, it is possible to change the shape of the aluminum-diamond composite 100 by adjusting the shape of the opening of the porous material 50. Due thereto, the production method of the present embodiment has a greater degree of freedom in terms of design than conventional methods in which molding is performed by a laser process, etc.

The laminated structure 40 which is formed in the block-forming step includes, in order, the first mold-release plate 6a, an aluminum layer 22, the mixed layer 21, an aluminum layer 22, and the second mold release plate 6b.

For the mixture layer 21, it is possible to use a mixture of the diamond particles obtained in the mixing step described above. The mixture layer 21 may, for example, be configured from diamond particles alone or may further include another component. The other component may, for example, be a binder such as silica, etc. When the mixture layer 21 includes another component, the content of the other component may, for example, be 0.5-3.0 mass% based on the total mass of the mixture layer 21.

The aluminum layer 22 may include inorganic fibers and, for example, may include alumina fibers, glass fibers, etc. The aluminum layer 22 may, for example, be an aluminum foil, an aluminum alloy foil, etc.

The thickness of the aluminum layer 22 may, for example, be 0.01 mm or more, 0.02 mm or more, or 0.03 mm or more. If the lower limit value of the thickness of the aluminum layer 22 is within the above ranges, it is possible to more adequately suppress diamond powder from being exposed on a surface of the aluminum-diamond composite 100, etc. The thickness of the aluminum layer 22 may, for example, be 0.20 mm or less, 0.15 mm or less, 0.10 mm or less, 0.08 mm or less, or 0.06 mm or less. If the upper limit value of the thickness of the aluminum layer 22 is within the above ranges, it is possible to sufficiently suppress a decrease in the thermal conductivity in the thickness direction of the obtained aluminum-diamond composite 100. The thickness can be adjusted within the ranges described above and may, for example, be 0.01-0.20 mm or 0.02-0.15 mm. The thickness of the aluminum layer 22 can be measured by using a micrometer, and is the arithmetic mean of values measured at five points of the surface. Note that the pair of aluminum layers 22 sandwiching the mixture layer 21 may have different thicknesses from one another or may have the same thickness.

For the first mold release plate 6a and the second mold release plate 6b, it is possible to use a plate having a dense structure which enables pressure to be sufficiently applied when a molten product of a metal containing aluminum is press-fitted and impregnated in the mixture layer 21 in the heating step described later. It is possible to use, for example, a stainless steel plate, a ceramic plate, etc., for the first mold release plate 6a and the second mold release plate 6b. A main surface on the mixture layer 21-side of the first mold release plate 6a and the second mold release plate 6b may have a mold release agent applied thereto or may undergo a mold release treatment. Examples of such a mold release agent include graphite, boron nitride, and alumina, etc. As the first mold release plate 6a and the second mold release plate 6b, it is possible, for example, to use a mold release plate having a main surface on the mixture layer 21-side on which alumina sol, etc., was used to form a coating layer and then a mold release agent was further adhered. By using such a mold release plate, mold releasing can be performed more stably and it is possible to make the main surface of the obtained aluminum-diamond composite 100 smoother.

The heating step can be performed by impregnating the structure 101 described above with a molten product of a metal containing aluminum. The temperature of the molten product may be 600-1500°C or may be 700-1300°C. With such a temperature, the molten product of the metal is supplied through the porous material 50, inside the mixture layer 21, and to the surface thereof. Due thereto, as shown in FIG. 4, there is formed, in a structure 102, the aluminum-diamond composite 100 (FIG. 1) having: the composite layer 10 containing aluminum and diamond; the first aluminum layer 20; and the second aluminum layer 30. Furthermore, a metal layer 24 may be formed on a side surface of the aluminum-diamond composite 100. The method for forming the aluminum-diamond composite 100 is described in detail below.

In the heating step, in addition to the metal layer 24, a molten product of a metal containing aluminum penetrates inside the aluminum layer 22 or the main surface on the mixture layer 21-side of the aluminum layer 22, and a first aluminum layer 20 and a second aluminum layer 30 may be formed. The aluminum layer 22 itself constitutes a metal-containing layer, and due to the molten product of the metal containing aluminum penetrating the main surface on the mixture layer 21-side of the aluminum layer 22, the composite layer 10, the first aluminum layer 20, and the second aluminum layer 30 are bonded robustly.

In the heating step, the method for supplying the molten product of the metal containing aluminum may, for example, be a so-called high-pressure forging method in which a molten product of a metal is impregnated into a target object at high pressure. From the perspective of obtaining an aluminum-diamond composite 100 having more excellent thermal conductivity, it is desirable to use a liquid metal forging method. The heating step is, for example, performed by immersing the structure 101 obtained in the block-forming step in a container filled with the molten product and applying pressure to the molten product. Due thereto, the molten product penetrates through fine pores that the porous material 50 has and is supplied between the inner circumferential surface 50a of the opening of the porous material 50 and the outer circumferential surface of the laminated structure, and thereafter, the molten product impregnates as far as the inside of the mixture layer 21, thereby making it possible to obtain a composite layer 10.

In addition to aluminum, the molten product of a metal containing aluminum may, for example, include another metal. Examples of the other metal include silicon, magnesium, and copper, etc. It is preferable that at least one of silicon and magnesium is included as another metal. Due to the molten product including a metal described above, it is possible to lower the melting point of the molten product and it is possible to lower the melt viscosity during impregnation, and therefore, the molten product can also sufficiently penetrate gaps in the mixture layer 21 that are configured between particles of the diamond powder. Due to such an action, it is possible to further improve the density of the composite layer 10 in the obtained aluminum-diamond composite 100. When the molten product includes silicon, the melting point can be further lowered, and when the molten product includes magnesium, bonding between the composite layer 10 and the aluminum layers can be made more robust.

When the molten product includes another metal in addition to aluminum, the content of the other metal may be 2-20 mass%, 2-15 mass%, or 5-15 mass% based on the total mass of the molten product.

When impregnating the molten product, it is desirable for the structure 101 to be preheated. The lower limit value of the heating temperature for preheating may, for example, be 520°C or more or 540°C or more. By setting the lower limit value of the heating temperature so as to be within the above ranges, it is easier to impregnate the molten product in the mixture layer 21 and metal impregnation in the heating step can be carried out more stably. The upper limit value of the heating temperature may, for example, be 750°C or less or 700°C or less. By setting the upper limit value of the heating temperature for the preheating so as to be within the above ranges, it is possible to further suppress the formation of aluminum carbide (Al₄C₃) when the diamond particles and aluminum are composited, and it is possible to further improve the thermal conductivity of the aluminum-diamond composite 100. The heating temperature may be adjusted within the ranges described above, and can be set so as to be, for example, 520-750°C or 540-700°C.

The pressure when the molten product is impregnated into the mixture layer 21 may, for example, be 20 MPa or more, 30 MPa or more, 40 MPa or more, or 50 MPa or more. By setting the lower limit value of the pressure when the molten product is impregnated into the mixture layer 21 so as to be within the ranges described above, the compositing in the heating step can be performed more stably and it is possible to further improve the thermal conductivity of the obtained aluminum-diamond composite 100. The pressure when the molten product is impregnated into the mixture layer 21 may, for example, be 150 MPa or less, 100 MPa or less, or 80 MPa or less. The pressure when the molten product is impregnated into the mixture layer 21 can be adjusted within the ranges described above, and may, for example, be 20-150 MPa.

After the heating step, the metal plate 60, the porous material 50, the first mold release plate 6a, and the second mold release plate 6b are removed from the structure 102, and the aluminum-diamond composite 100 shown in FIG. 1 can be extracted. The aluminum-diamond composite 100 may be cut out from the structure 102 by performing a water jet process or a laser process, etc. A surface treatment may be performed to smoothen the surface of the obtained aluminum-diamond composite 100. The surface treatment may employ a normal processing method employed in metal processing, and for example, polishing, surface grinding, etc., may be performed.

An annealing process may be performed on the obtained aluminum-diamond composite 100. In the annealing step, after the heating step, a heat treatment is performed at a relatively low temperature to reduce any distortion, etc., that the composite layer 10, the first aluminum layer 20, the second aluminum layer 30, and the metal layer 24, etc., may have. Such a step makes it possible to produce an aluminum-diamond composite 100 having a more excellent thermal conductivity. The heating temperature in the annealing step may, for example, be 400-550°C or 400-500°C. The heating time in the annealing step may, for example, be ten minutes or more or 20 minutes or more, and further, may be 24 hours or less or 12 hours or less.

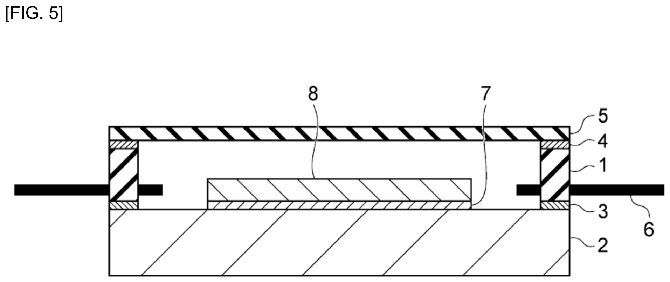

FIG. 5 shows an example of a semiconductor package which uses a heat dissipation member including the aluminum-diamond composite 100. The semiconductor package in FIG. 5 can be obtained by bonding a semiconductor element 8 to a heat dissipation member 2, bonding an insulation member 1 and a lid member 5 to one another so as to enclose the semiconductor element 8, and bonding the insulation member 1 to the heat dissipation member 2. The semiconductor package is connected to an external terminal (not shown) via a conductive wire 6. The heat dissipation member 2 and the semiconductor element 8 are bonded via a bonding material 7. The heat dissipation member 2 and the lower surface of the insulation member 1 are bonded via a bonding material 3. The upper surface of the insulation member 1 and the lid member 5 are bonded via a bonding material 4. It is possible to use, for example, alumina, aluminum nitride, silicon nitride, and beryllium oxide, etc., for the insulation member 1. Since the heat dissipation member 2 of such a semiconductor package includes an aluminum-diamond composite 100 having a high thermal conductivity, it is possible to obtain a semiconductor package having an even more improved heat dissipation.

Several embodiments of the present disclosure were described above, but the present disclosure is not in any way limited to the above embodiments. For example, the aluminum-diamond composite 100 may have a metal layer on a side surface of the composite layer 10.

### EXAMPLES

The features of the present disclosure are described in more detail below with reference to examples and comparative examples. Note that the present disclosure is not limited to the examples described below.

### (Example 1)

A high purity diamond powder A (average particle diameter: 180 µm, manufactured by Saint-Gobain S.A.) and a high purity diamond powder B (average particle diameter: 20 µm, manufactured by Saint-Gobain S.A.), which are both commercially available, were loaded into a V-type mixer (product name: V-10, manufactured by Tokuju Co., Ltd.) so as to have a mass ratio of A:B=7:3. The volume ratio of diamond particles relative to the total capacity of the V-type mixer was 17%. The V-type mixer was rotated for ten minutes at a rotational speed of 25 rpm to mix the diamond powders and obtain a mixture of the diamond powders A and B. A mold release plate was fabricated by coating alumina sol on a surface of a stainless steel plate (SUS430) of length × width × thickness = 40 mm × 40 mm × 2 mm and performing a baking treatment for 30 minutes at 350°C.

An isotropic graphite jig with a degree of porosity of 20% was prepared, having an outer form of length × width × thickness = 60 mm × 60 mm × 8 mm, and having, in a central section, a though-hole of length × width × thickness = 40 mm × 40 mm × 8 mm. The isotropic graphite jig was placed on a 12 mm-thick iron plate having bolt holes in the four corners thereof such that the opening of the through-hole was oriented upwards. A mold release plate and a 30 µm-thick pure aluminum foil (manufactured by UACJ Corporation) were inserted in said order into the through-hole from above to laminate the pure aluminum foil on the mold release plate inside the through-hole. Furthermore, a mixture layer was formed by filling the mixture of diamond powders described above on the pure aluminum foil so as to have a thickness of 1.24 mm. A pure aluminum foil and a mold release plate were laminated in said order on the mixture layer to form a laminated structure inside the through-hole.

The same procedure was repeated to form six such laminated structures inside the through-hole. Thereafter, a stainless steel plate of length × width × thickness = 60 mm × 60 mm × 1 mm and having a graphite-based mold release agent applied thereto was inserted into the through-hole on the laminated structures, and the laminated structures were sandwiched by a pair of stainless steel plates. A 12 mm-thick iron plate having bolt holes in the four corners thereof was placed on the isotropic graphite jig so as to cover the through-hole. One block was obtained by joining the iron plates disposed on the top and bottom to one another using six M10 bolts and tightening with a torque wrench so that the surface direction tightening torque was 10 N·m.

The obtained block was preheated to a temperature of 650°C in an electric furnace and then accommodated inside a preheated press die having an inner diameter of 300 mm. A molten aluminum alloy containing 12 mass% silicon and 1 mass% magnesium and having a temperature of 800°C was poured into a press die and pressurized for 20 minutes at a pressure of 100 MPa. Due thereto, the aluminum alloy was impregnated into the mixture layer to obtain a composite layer including an aluminum alloy and the diamond powders A and B. After cooling the block having the composite layer formed therein to room temperature, a wet band saw was used to cut along the shape of the mold release plate and the stainless steel plate was peeled away to obtain a cut piece. An annealing treatment was then carried out in which the cut piece was heated at a temperature of 400°C for three hours to eliminate any distortion caused during impregnation. Then, after polishing the surface of the aluminum layer in the cut piece using a #600 polishing paper, a buffing treatment was performed. Thus, there was obtained a laminated body provided with, in order, a first aluminum layer, a composite layer, and a second aluminum layer.

After ultrasonic cleaning the surface of the laminated body, the main surfaces of the first aluminum layer and the second aluminum layer were pretreated with a Zn catalyst. The pretreated surfaces of the first aluminum layer and the second aluminum layer sequentially underwent Ni electrolytic plating, Ni-P non-electrolytic plating, and Au electrolytic plating to form a 6 µm-thick plating layer (Ni: 2.0 µm + NiP: 2.0 µm + Au: 2.0 µm) on the surface of the aluminum-diamond composite.

Next, the aluminum-diamond composite was processed to a shape of length × width × thickness = 25 mm × 25 mm × 2 mm by a YAGI laser processor to obtain the aluminum-diamond composite of Example 1.

### (Examples 2 and 3)

The aluminum-diamond composites of Examples 2 and 3 were obtained by the same procedure as for Example 1.

### (Comparative Example 1)

The aluminum-diamond composite of Comparative Example 1 was obtained by the same procedure as for Examples 1-3 except that the diamond mixture was obtained by being stirred manually by a worker for five minutes instead of by the V-type mixer.

### (Comparative Example 2)

Instead of filling the through-hole of the isotropic graphite jug with a mixture of diamond powders, a diamond powder was filled by putting in the diamond powder A and then putting in the diamond powder B from above so as to achieve a mass ratio of 7:3. In other respects, the aluminum-diamond composite of Comparative Example 2 was obtained by the same procedure as for Examples 1-3.

### [Measurement of thermal conductivity]

The thermal conductivity at 25°C of the aluminum-diamond composites of each example and each comparative example was measured by using a laser flash method (product name: LF/TCM-8510B, manufactured by Rigaku Corp.) The results are shown in Tables 2 and 4.

### [Calculation of surface area ratio and particle count ratio of diamond particles in cut section]

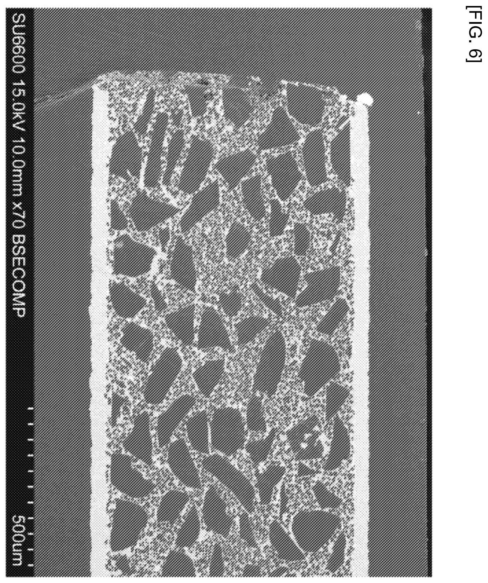

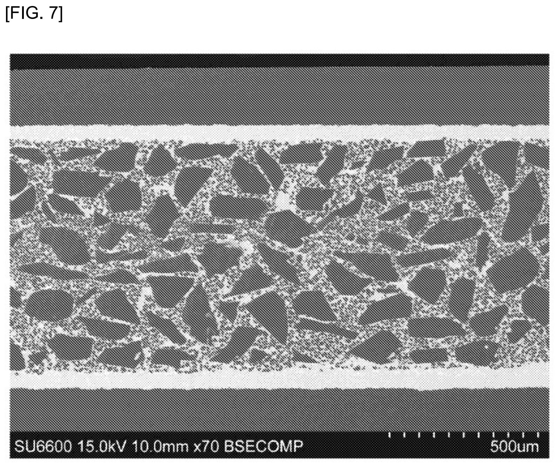

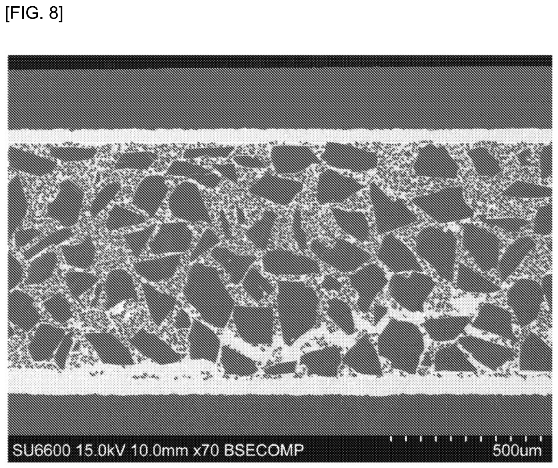

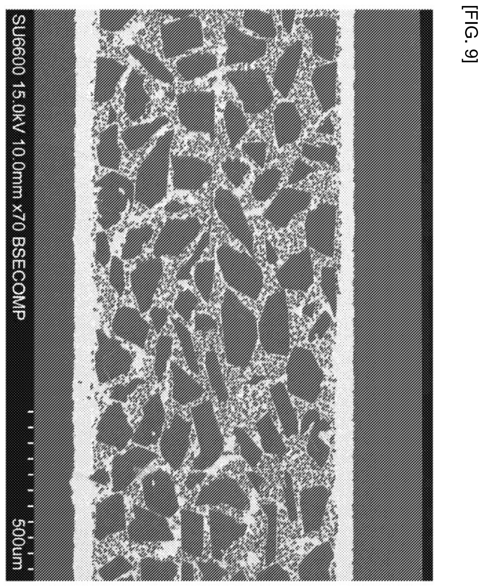

The aluminum-diamond composite of each example and each comparative example was cut, using a YAG laser processor, at four locations along a direction orthogonal to the main surfaces of the first aluminum layer and the second aluminum layer to obtain four cut pieces. A cross-section polisher was used to polish the cut sections and each cut section was observed at a magnification of 70 X using a scanning electron microscope (SEM). FIG. 6 is an SEM photograph showing a cut section of No. 1 in Example 1. FIG. 7 is an SEM photograph showing a cut section of No. 2 in Example 1. FIG. 8 is an SEM photograph showing a cut section of No. 3 in Example 1. FIG. 9 is an SEM photograph showing a cut section of No. 4 in Example 1. As shown in FIG. 6-9, there was a composite layer of the aluminum-diamond composite present so as to be sandwiched between the first aluminum layer and the second aluminum layer. Further, in the composite layer, coarse diamond particles and fine diamond particles were dispersed in the aluminum phase.

A section in the obtained SEM images that extends 200 µm into the composite layer from a first boundary line between the first aluminum layer and the composite layer was deemed to be a first region. As shown in FIG. 2, the first boundary line touches the outer edge A of the diamond particle 84 which is the closest diamond particle to the first aluminum layer 20, and is a tangent drawn parallel to the main surface of the first aluminum layer 20. Further, a section in the obtained SEM images that extends 200 µm into the composite layer from a second boundary line between the second aluminum layer and the composite layer was deemed to be a second region. The second boundary line passes through an outer edge of a diamond particle positioned closest to the second aluminum layer, and is a tangent drawn parallel to the main surface of the second aluminum layer.

ImageJ was used to perform image analysis of the first region and the second region in each cut section. Diamond particles having a surface area of 2000 µm² or more were deemed to be coarse particles, and diamond particles having a surface area of less than 2000 µm² were deemed to be fine particles. The surface area and particle count of the coarse particles and the fine particles were measured in each first region and second region. The results are shown in Tables 1 and 3.

Table 1 and Table 2 show: the total surface area of the diamond particles in each region; the ratio of the total surface area of the coarse particles relative to the total surface area of the diamond particles; average values (α1, α2) of the ratio for each first region and second region; an average value α of the ratio for the first region and second region combined; and the absolute value of a difference between the average value α1 of the first region and the average value α2 of the second region.

Table 3 and Table 4 show: the particle count (total X) of the diamond particles in each cut section; the ratio of the particle count of coarse particles relative to the total X; average values (β1, β2) of the ratio for each first region and second region; an average value β of the ratio for the first region and second region combined; and the absolute value of a difference between the average value β1 of the first region and the average value β2 of the second region. Note that in Tables 1-4, the same number, among No. 1 to No. 4 in one example, is used to indicate results for a first region and a second region in the same cut section.

**TABLE 1**

| | | | SURFACE AREA (µm²) | | | COARSE PARTICLE |
|---|---|---|---|---|---|---|
| | | | TOTAL | COARSE PARTICLES | FINE PARTICLES | SURFACE AREA RATIO |
| EX.1 | FIRST REGION | No.1 | 204668.8 | 151340.4 | 53328.5 | 73.9% |
| | | No.2 | 236857.5 | 180398.0 | 56459.5 | 76.2% |
| | | No.3 | 237102.4 | 166235.0 | 70867.5 | 70.1% |
| | | No.4 | 211674.8 | 156247.7 | 55427.1 | 73.8% |
| | SECOND REGION | No.1 | 214377.7 | 160758.4 | 53619.3 | 75.0% |
| | | No.2 | 228442.3 | 176247.801 | 52194.5 | 77.2% |
| | | No.3 | 203372.9 | 148662.797 | 54710.1 | 73.1% |
| | | No.4 | 182550.1 | 127374.6 | 55175.5 | 69.8% |
| EX.2 | FIRST REGION | No.1 | 206006.8 | 150646.8 | 55360.0 | 73.1% |
| | | No.2 | 224979.2 | 161690.7 | 63288.5 | 71 .9% |
| | | No.3 | 242273.0 | 199227.9 | 43045.1 | 82.2% |
| | | No.4 | 187489.6 | 149803.6 | 37686.1 | 79.9% |
| | SECOND REGION | No.1 | 197782.8 | 145700.9 | 52081.9 | 73.7% |
| | | No.2 | 228570.1 | 177588.3 | 50981.9 | 77.7% |
| | | No.3 | 240265.4 | 187538.5 | 52727.0 | 78.1% |
| | | No.4 | 190105.1 | 147367.6 | 42737.5 | 77.5% |
| EX.3 | FIRST REGION | No.1 | 218669.5 | 181280.0 | 37389.5 | 82.9% |
| | | No.2 | 219728.5 | 169447.0 | 50281.5 | 77.1% |
| | | No.3 | 246313.2 | 202251.7 | 44061.6 | 82.1% |
| | | No.4 | 216888.8 | 172796.3 | 44092.6 | 79.7% |
| | SECOND REGION | No.1 | 209101.4 | 167744.8 | 41356.6 | 80.2% |
| | | No.2 | 237404.7 | 180186.6 | 57218.1 | 75.9% |
| | | No.3 | 239399.6 | 181698.0 | 57701.6 | 75.9% |
| | | No.4 | 177822.2 | 120369.2 | 57453.0 | 67.7% |
| COMP. EX.1 | FIRST REGION | No.1 | 176388.3 | 153395.0 | 22992.4 | 87.0% |
| | | No.2 | 240375.5 | 185235.7 | 55139.8 | 77.1% |
| | | No.3 | 248256.7 | 195239.7 | 53017.0 | 78.6% |
| | | No.4 | 241358.8 | 184601.7 | 56757.1 | 76.5% |
| | | No.5 | 229390.2 | 167387.499 | 62002.704 | 73.0% |
| | SECOND REGION | No.1 | 196127.0 | 162392.1 | 33734.9 | 82.8% |
| | | No.2 | 252178.8 | 216677.8 | 35501.0 | 85.9% |
| | | No.3 | 257264.9 | 220330.0 | 36934.9 | 85.6% |
| | | No.4 | 248427.5 | 198380.2 | 50047.2 | 79.9% |
| | | No.5 | 252881.8 | 204981.4 | 47900.4 | 81.1% |
| COMP. EX.2 | FIRST REGION | No.1 | 143810.4 | 21809.1 | 122001.365 | 15.2% |
| | | No.2 | 153457.4 | 0 | 153457.422 | 0.0% |
| | | No.3 | 144716.6 | 0 | 144716.634 | 0.0% |
| | | No.4 | 156562.9 | 0 | 156562.854 | 0.0% |
| | SECOND REGION | No.1 | 205791.5 | 194673.2 | 11118.3 | 94.6% |
| | | No.2 | 210608.4 | 198381.3 | 12227.1 | 94.2% |
| | | No.3 | 190216.1 | 173120.9 | 17095.2 | 91.0% |
| | | No.4 | 220943.2 | 210861.4 | 10081.9 | 95.4% |

**TABLE 2**

| | | | AVERAGE VALUE OF SURFACE AREA RATIOS (α1, α2) | AVERAGE VALUE OF SURFACE AREA RATIOS α | DIFFERENCE BETWEEN AVERAGE VALUE OF SURFACE AREA RATIOS \|α1 - α2\| | THERMAL CONDUCTIVITY (W·m⁻¹·K⁻¹) |
|---|---|---|---|---|---|---|
| EX.1 | FIRST REGION | No.1 | 73.5% | 73.7% | 0.5% | 578 |
| | | No.2 | | | | |
| | | No.3 | | | | |
| | | No.4 | | | | |
| | SECOND REGION | No.1 | 74.0% | | | |
| | | No.2 | | | | |
| | | No.3 | | | | |
| | | No.4 | | | | |
| EX.2 | FIRST REGION | No.1 | 76.8% | 76.8% | 0.0% | 553 |
| | | No.2 | | | | |
| | | No.3 | | | | |
| | | No.4 | | | | |
| | SECOND REGION | No.1 | 76.8% | | | |
| | | No.2 | | | | |
| | | No.3 | | | | |
| | | No.4 | | | | |
| EX.3 | FIRST REGION | No.1 | 80.5% | 77.9% | 5.2% | 538 |
| | | No.2 | | | | |
| | | No.3 | | | | |
| | | No.4 | | | | |
| | SECOND REGION | No.1 | 75.3% | | | |
| | | No.2 | | | | |
| | | No.3 | | | | |
| | | No.4 | | | | |
| COMP. EX.1 | FIRST REGION | No.1 | 78.0% | 80.7% | 5.1% | 495 |
| | | No.2 | | | | |
| | | No.3 | | | | |
| | | No.4 | | | | |
| | | No.5 | | | | |
| | SECOND REGION | No.1 | 83.1% | | | |
| | | No.2 | | | | |
| | | No.3 | | | | |
| | | No.4 | | | | |
| | | No.5 | | | | |
| COMP. EX.2 | FIRST REGION | No.1 | 3.6% | 48.8% | 90.3% | 98 |
| | | No.2 | | | | |
| | | No.3 | | | | |
| | | No.4 | | | | |
| | SECOND REGION | No.1 | 93.9% | | | |
| | | No.2 | | | | |
| | | No.3 | | | | |
| | | No.4 | | | | |

**TABLE 3**

| | | | PARTICLE COUNT (PARTICLES) | | | PARTICLE COUNT RATIO OF COURSE PARTICLES |
|---|---|---|---|---|---|---|
| | | | TOTAL X | COARSE PARTICLES | FINE PARTICLES | |
| EX.1 | FIRST REGION | No.1 | 1608 | 19 | 1589 | 1.2% |
| | | No.2 | 1558 | 21 | 1537 | 1.3% |
| | | No.3 | 1711 | 16 | 1695 | 0.9% |
| | | No.4 | 1437 | 14 | 1423 | 1.0% |
| | SECOND REGION | No.1 | 847 | 18 | 829 | 2.1% |
| | | No.2 | 1216 | 22 | 1194 | 1.8% |
| | | No.3 | 1201 | 24 | 1177 | 2.0% |
| | | No.4 | 1535 | 16 | 1519 | 1.0% |
| EX.2 | FIRST REGION | No.1 | 1482 | 18 | 1464 | 1.2% |
| | | No.2 | 1349 | 18 | 1331 | 1.3% |
| | | No.3 | 994 | 20 | 974 | 2.0% |
| | | No.4 | 1347 | 13 | 1334 | 1.0% |
| | SECOND REGION | No.1 | 1132 | 18 | 1114 | 1.6% |
| | | No.2 | 2390 | 20 | 2370 | 0.8% |
| | | No.3 | 1081 | 26 | 1055 | 2.4% |
| | | No.4 | 1316 | 17 | 1299 | 1.3% |
| EX.3 | FIRST REGION | No.1 | 1541 | 17 | 1524 | 1.1% |
| | | No.2 | 1362 | 20 | 1342 | 1.5% |
| | | No.3 | 1499 | 21 | 1478 | 1.4% |
| | | No.4 | 1118 | 19 | 1099 | 1.7% |
| | SECOND REGION | No.1 | 1557 | 14 | 1543 | 0.9% |
| | | No.2 | 1681 | 20 | 1661 | 1.2% |
| | | No.3 | 1179 | 16 | 1163 | 1.4% |
| | | No.4 | 1557 | 14 | 1543 | 0.9% |
| COMP. EX. 1 | FIRST REGION | No.1 | 339 | 15 | 324 | 4.4% |
| | | No.2 | 895 | 21 | 874 | 2.3% |
| | | No.3 | 851 | 24 | 827 | 2.8% |
| | | No.4 | 653 | 20 | 633 | 3.1% |
| | | No.5 | 1053 | 22 | 1031 | 2.1% |
| | SECOND REGION | No.1 | 744 | 16 | 728 | 2.2% |
| | | No.2 | 945 | 18 | 927 | 1.9% |
| | | No.3 | 821 | 16 | 805 | 1.9% |
| | | No.4 | 939 | 21 | 918 | 2.2% |
| | | No.5 | 883 | 19 | 864 | 2.2% |
| COMP. EX.2 | FIRST REGION | No.1 | 2124 | 2 | 2122 | 0.1% |
| | | No.2 | 1737 | 0 | 1737 | 0.0% |
| | | No.3 | 2109 | 0 | 2109 | 0.0% |
| | | No.4 | 2077 | 0 | 2077 | 0.0% |
| | | No.1 | 261 | 25 | 236 | 9.6% |
| | SECOND REGION | No.2 | 241 | 21 | 220 | 8.7% |
| | | No.3 | 230 | 24 | 206 | 10.4% |
| | | No.4 | 127 | 22 | 105 | 17.3% |

**TABLE 4**

| | | | AVERAGE VALUE OF PARTICLE COUNT RATIOS (β1, β2) | AVERAGE VALUE OF PARTICLE COUNT RATIOS β | DIFFERENCE BETWEEN AVERAGE VALUE OF PARTICLE COUNT RATIOS \|β1 - β2\| | THERMAL CONDUCTIVITY (W·m⁻¹·k⁻¹) |
|---|---|---|---|---|---|---|
| EX.1 | FIRST REGION | No.1 | 1.1% | 1.4% | 0.6% | 578 |
| | | No.2 | | | | |
| | | No.3 | | | | |
| | | No.4 | | | | |
| | SECOND REGION | No.1 | 1.7% | | | |
| | | No.2 | | | | |
| | | No.3 | | | | |
| | | No.4 | | | | |
| EX.2 | FIRST REGION | No.1 | 1.3% | 1.35% | 0.0% | 553 |
| | | No.2 | | | | |
| | | No.3 | | | | |
| | | No.4 | | | | |
| | SECOND REGION | No.1 | 1.4% | | | |
| | | No.2 | | | | |
| | | No.3 | | | | |
| | | No.4 | | | | |
| EX.3 | FIRST REGION | No.1 | 1.4% | 1.25% | 0.3% | 538 |
| | | No.2 | | | | |
| | | No.3 | | | | |
| | | No.4 | | | | |
| | SECOND REGION | No.1 | 1.1% | | | |
| | | No.2 | | | | |
| | | No.3 | | | | |
| | | No.4 | | | | |
| COMP. EX.1 | FIRST REGION | No.1 | 2.7% | 2.4% | 0.6% | 495 |
| | | No.2 | | | | |
| | | No.3 | | | | |
| | | No.4 | | | | |
| | | No.5 | | | | |
| | SECOND REGION | No.1 | 2.1% | | | |
| | | No.2 | | | | |
| | | No.3 | | | | |
| | | No.4 | | | | |
| | | No.5 | | | | |
| | | No.1 | 0.0% | 5.35% | 10.7% | 98 |
| COMP. EX.2 | FIRST REGION | No.2 | | | | |
| | | No.3 | | | | |
| | | No.4 | | | | |
| | SECOND REGION | No.1 | 10.7% | | | |
| | | No.2 | | | | |
| | | No.3 | | | | |
| | | No.4 | | | | |

As shown in Table 2 and Table 4, aluminum-diamond composites which use the mixture of diamond powders in Examples 1-3 had a high thermal conductivity compared to Comparative Example 1 and Comparative Example 2. Further, as shown in Table 2, in each aluminum-diamond composite, upon comparing the average value α of the surface area ratio of the coarse particles in the first region and the second region, in Examples 1-3, the value was 73.7-77.9%. Meanwhile, the average value α in Comparative Example 1 was high at 80.7% and the average value α in Comparative Example 2 was low at 48.8%. Furthermore, as shown in Table 4, the average value β of the ratio of the particle count of coarse diamond particles relative to the total particle count of the diamond particles calculated for each region was less than 2.0% in all of Examples 1-3. Thus, for the aluminum-diamond composites of Examples 1-3, it was confirmed that diamond particles having a high thermal conductivity are appropriately distributed in the aluminum phase.

### INDUSTRIAL APPLICABILITY

According to the present disclosure, it is possible to provide: an aluminum-diamond composite having a sufficiently high thermal conductivity; and a method for producing the same. Further, it is possible to provide a semiconductor package which has excellent heat dissipation due to including such an aluminum-diamond composite.

### REFERENCE SIGNS LIST

- 100: Aluminum-diamond composite
- 100a, 100b: Main surface
- 20: First aluminum layer
- 30: Second aluminum layer
- 10: Composite layer
- 80: First region
- 85: Central region
- 90: Second region
- 82: First boundary line
- 92: Second boundary line
- VL1: First virtual line
- VL2: Second virtual line
- 84: Diamond particle
- 86: Aluminum phase
- A: Outer edge
- 21: Mixture layer
- 22: Aluminum layer
- 40: Laminated structure
- 50: Porous material
- 60: Metal plate
- 50a: Inner circumferential surface
- S: Gap
- g: Distance
- 24: Metal layer
- 101, 102: Structure
- 1: Insulation member
- 2: Heat dissipation member
- 3, 4, 7: Bonding material
- 5: Lid member
- 6: Conductive wire
- 6a: First mold release plate
- 6b: Second mold release plate
- 8: Semiconductor element

## Claims

1. An aluminum-diamond composite comprising a laminated structure having a composite layer comprising an aluminum phase and a plurality of diamond particles having different sizes from one another, and a pair of aluminum layers sandwiching the composite layer, wherein:
in a cut section obtained by cutting along the laminating direction,
the plurality of diamond particles comprise coarse particles having a surface area of 2000 µm² or more and fine particles having a surface area of less than 2000 µm²; and
in a region extending 200 µm into the composite layer from a boundary line between the pair of aluminum layers and the composite layer, an average value α of a ratio of the total surface area of the coarse particles relative to the total surface area of the plurality of diamond particles is 65-80%.

2. The aluminum-diamond composite according to claim 1, wherein in said region, an average value β of a ratio of a particle count of the coarse particles relative to a particle count of the plurality of diamond particles is 2.0% or less.

3. The aluminum-diamond composite according to claim 2, wherein:
the region comprises a first region which is a region that extends 200 µm into the composite layer from a boundary line between one of the pair of aluminum layers and the composite layer, and a second region which is a region that extends 200 µm into the composite layer from a boundary line between the other of the aluminum layers and the composite layer; and
an absolute value of a difference between an average value β1 of a ratio of the particle count of the coarse particles relative to the particle count of the plurality of diamond particles in the first region and an average value β2 of a ratio of the particle count of the coarse particles relative to the particle count of the plurality of diamond particles in the second region is 0.6% or less.

4. The aluminum-diamond composite according to any one of claims 1 to 3, wherein:
the region comprises a first region which is a region that extends 200 µm into the composite layer from a boundary line between one of the pair of aluminum layers and the composite layer, and a second region which is a region that extends 200 µm into the composite layer from a boundary line between the other of the aluminum layers and the composite layer; and
an absolute value of a difference between an average value α1 of a ratio of the total surface area of the coarse particles relative to the total surface area of the plurality of diamond particles in the first region and an average value α2 of a ratio of the total surface area of the coarse particles relative to the total surface area of the plurality of diamond particles in the second region is 6.0% or less.

5. A method for producing an aluminum-diamond composite, the method comprising:
a mixing step in which a V-type mixer is used to mix coarse diamond particles and fine diamond particles that have different sizes from one another to obtain a mixture comprising a plurality of diamond particles; and
a heating step in which the mixture is heated in a state of being sandwiched by aluminum foil to obtain a laminated structure comprising a composite layer comprising an aluminum phase and the mixture, and a pair of aluminum layers sandwiching the composite layer.

6. The method for producing an aluminum-diamond composite according to claim 5, wherein:
in a cut section obtained by cutting the aluminum-diamond composite along the laminating direction,
the plurality of diamond particles comprise the coarse particles which have a surface area of 2000 µm² or more and the fine particles which have a surface area of less than 2000 µm²; and
in a region extending 200 µm into the composite layer from a boundary line between the pair of aluminum layers and the composite layer, an average value α of a ratio of the total surface area of the coarse particles relative to the total surface area of the plurality of diamond particles is 65-80%.

7. The method for producing an aluminum-diamond composite according to claim 5 or 6, wherein the method comprises, in the mixing step, rotating the V-type mixer at a rotational speed of 15-50 rpm for 5-30 minutes.

8. The method for producing an aluminum-diamond composite according to claim 5 or 6, wherein in the mixing step, a ratio of the volume of the plurality of diamond particles relative to the total capacity of the V-type mixer is 10-50%.

9. A semiconductor package comprising: a heat dissipation member comprising the aluminum-diamond composite according to any one of claims 1 to 3; and a semiconductor element bonded to the heat dissipation member.
